# EUROPEAN PATENT SPECIFICATION

(11) **EP 3 782 183 B1**
(45) Date of publication and mention of the grant of the patent: **15.03.2023**
(21) Application number: 19717330.5
(22) Date of filing: 17.04.2019
(51) Int. Cl.: H01J 37/32, H01J 37/34

(54) **PLASMA CLEANING APPARATUS**
PLASMAREINIGUNGSVORRICHTUNG
APPAREIL DE NETTOYAGE AU PLASMA

(30) Priority: 17.04.2018 EP 18167820
(43) Date of publication of application: 24.02.2021
(73) Proprietor: Tata Steel Nederland Technology B.V., 1951 JZ Velsen-Noord (NL)
(72) Inventor: WESTERWAAL, Ruud Johannes, 1970 CA IJmuiden (NL); BOUWENS, Antonius Johannes Petrus, 1970 CA IJmuiden (NL); COMMANDEUR, Colin, 1970 CA IJmuiden (NL); ZOESTBERGEN, Edzo, 1970 CA IJmuiden (NL); BOELSMA, Christiaan, 1970 CA IJmuiden (NL)
(74) Representative: Group Intellectual Property Services
(86) International application number: PCT/EP2019/059957
(87) International publication number: WO 2019/202011

(56) References cited:
- WO-A1-2017/029320
- US-A- 5 113 790
- US-B1- 6 403 490

## Description

### Field of the invention

The invention relates to a plasma cleaning apparatus unit used for cleaning substrates, more in particular a magnetron plasma cleaning apparatus for cleaning metal substrates.

### Background of the invention

In various applications wherein a thin film or coating has to be applied on a substrate it is often not sufficient to use only simple mechanical and/or chemical cleaning methods. After one or more initial cleaning steps of a substrate often plasma cleaning is applied as a final cleaning step before a thin film or coating is applied. With the plasma cleaning of the substrate the last contaminations present on the substrate can be removed. After plasma cleaning a substrate the adhesion of a subsequently applied thin film or coating to the substrate is increased considerably.

Plasma cleaning is performed with a plasma cleaning apparatus and more favourably with a magnetron plasma cleaning apparatus. In the description this term is used interchangeable with plasma sputter cleaning and sputter cleaning. In a plasma cleaning apparatus a gas is fed into an ionisation chamber where the gas is ionised by a voltage difference between the ionisation chamber and the substrate. The gas is preferably Argon gas or Argon based gas because of its high atomic mass. The Ar ions bombard the steel strip surface and thereby remove the contaminations, oxides and surface enrichments and at the same time it activates the surface. Subsequently a coating can be applied to the steel surface.

The plasma near the steel strip is densified due to the presence of magnets. Electrons expelled from the substrate by secondary emission are also trapped in the magnetic field, which prevents them from getting lost in the environment or at the anode. The electrons move in a direction along the surface of the steel sheet. This increased electron density results in a higher Ar ion concentration close to the steel sheet and thus in an increased sputter intensity.

With the known plasma cleaning devices the ionisation chamber and other parts of the apparatus are contaminated by re-deposition of removed surface material from the substrate, such as a steel strip. This causes short circuit effects, building up of debris and a reduction in the steel surface preparation efficiency. As a result the plasma cleaning apparatus has to be cleaned regularly, which is a time consuming process resulting in long downtime of the plasma cleaning apparatus. Examples of prior art plasma devices with magnets are disclosed in US 5 113 790 A, WO 2017/029320 A1 and US 6 403 490 B1.

### Objectives of the invention

It is an objective of the present invention to provide a plasma cleaning apparatus with reduced contamination of the ionisation chamber.

It is another objective of the present invention to provide a plasma cleaning apparatus with reduced downtime.

It is another objective of the present invention to provide a plasma cleaning apparatus with reduced maintenance time.

It is another objective of the present invention to provide a plasma cleaning apparatus which is suitable to be used to clean substrates of ferromagnetic materials independent of the thickness of the substrate.

### Description of the invention

One or more of the objectives of the invention are realized by providing a plasma cleaning apparatus according to claim 1 comprising an ionisation chamber provided with an opening, wherein with the apparatus in operation the opening is facing a substrate to be cleaned, a gas supply, a power supply for the ionisation of the gas, a plurality of magnets provided in at least one row parallel to a plane defined by the opening of the ionisation chamber, wherein the plurality of magnets are placed inside the ionisation chamber, wherein the at least one row of magnets is contained in a shielding of non-magnetic material.

The advantage of positioning the magnets inside the ionisation chamber is that the thickness of the metal substrate is no longer of any importance for the cleaning of the substrate. In the known situation with the magnets outside the ionisation chamber at the other side of the steel substrate to be cleaned the ferromagnetic substrate will short circuit part of the magnetic field thereby reducing its strength and thus efficiency. This applies especially for thicker substrates.

The magnetic field is applied with the plurality of magnets provided in at least one row parallel to a plane defined by opening of the ionisation chamber. The (dipole, multi-pole) magnets are permanent magnets which are typically positioned with the magnetic axis in series in a North-South configuration and spaced from each other. However other magnet configurations are also possible like for example, with rows of magnets with the magnetic axis parallel to each to other and perpendicular to a plane defined by opening of the ionisation chamber wherein the magnets in successive rows are oriented North-South and South-North.

It was found that a single row of magnets is less effective than a number of rows of magnets parallel to each other. Good results have been achieved with a configuration wherein the plurality of magnets are provided in three or more rows parallel to each other. The optimal number of rows of magnets is dependent on the size of the ionisation chamber which again is dependent on the size of the substrate to be treated.

With the plurality of magnets inside the ionisation chamber the contamination with the removed surface material of the substrate by the plasma cleaning/etching process not only affects the inside of the ionisation chamber but the material will also be deposited on the magnets. In order to obviate that problem it is provided that a row of magnets is contained in a shielding of non-magnetic material. Any deposition of removed surface material will not be directly on the magnets itself but on the shielding. The shielding around the magnets in itself will reduce the influence of re-deposited debris on the magnetic field.

According to a further aspect it is provided that the shielding of the row of magnets is mounted rotatable in the ionisation chamber. This has the advantage that when the magnetic field is effected by debris deposited on the shielding, which will be debris on the part of the shielding facing the steel substrate, it can simply be turned over an angle such that a clean part of the shielding is facing the substrate again. This will increase the runtime of the cleaning apparatus considerably.

In order to be able to rotate the shielding of a row of magnets the shielding is provided with pivot axles at opposite ends which are in line with each other and wherein at least one of the pivot axes protrudes to outside the ionisation chamber. Since the row of magnets are inside the ionisation chamber, which is under a high positive voltage (the steel strip is grounded) the pivot axles are electrically insulated from the container defining the ionisation chamber. The pivot axis extending out of the ionisation chamber can be used for rotating the shielding.

The steel strip will heat up as function of sputter cleaning of the strip and since the row of magnets is close to the steel strip the magnets will also heat up. In order to maintain the properties of the magnets the temperature of the magnets should not increase too much.

In order to avoid a too large increase of temperature it is further provided that the shielding is a closed body wherein the pivot axles at opposite ends are respectively an inlet and an outlet for a cooling medium. With such a cooling, for instance by using water as a cooling medium, the temperature of the magnets can be maintained below a certain temperature where the magnets will maintain their magnetic properties. With the magnets inside the ionisation chamber, which is under a high positive voltage (the steel strip is grounded) the cooling system should be electrically insulated from the ionisation chamber. By taking the pivot axles as inlet and outlet for the cooling medium, which are already insulated from the ionisation chamber, there is no separate insulation needed for the cooling system.

A further embodiment provides that a cooling tube for a cooling medium is provided inside the shielding and wherein the pivot axis of the shielding connect to the cooling tube and serve as inlet and outlet for the cooling medium. By using a cooling tube inside the shielding instead of having a closed body for the shielding and use the whole shielding for the cooling medium the cooling of the row of magnets can be better controlled.

Using the pivot axis as inlet and outlet, implying that the pivot axis are hollow, means that both the shielding and cooling tube are rotated when the shielding is rotated.

Another embodiment provides that a cooling tube for a cooling medium is provided inside the shielding, wherein the pivot axles of the shielding are hollow, wherein an inlet line and an outlet line for a cooling medium are provided coaxially inside the pivot axis of the shielding, wherein inlet line and an outlet line and pivot axis are rotatable with respect to each other, and wherein inlet line and an outlet line connect to the cooling tube. With this embodiment the shielding can be rotated whereas the cooling tube can be hold in a fixed position or wherein both shielding and cooling tube can be rotated independently from each other.

According to a further aspect it is provided that the row of magnets in the shielding are provided inside the cooling tube for the cooling medium. In this configuration the cooling of the magnets is direct and efficient, be it that fixing the magnets into position and maintenance could be more complicated.

According to still a further aspect it is provided that the row of magnets in the shielding are provided against the cooling tube for the cooling medium, that is against the outside of the cooling tube. In this configuration replacement of the magnets for whatever reason is easier than with the magnets insided the cooling tube.

According to another aspect the magnets together with the cooling tube are hold in a retaining tube. With such a construction the magnets can easily be hold in position and against the cooling tube. The retaining tube fits within the shielding.

Dependent on the configuration of the magnets within a row of magnets and/or the configuration of magnets in multiple rows of magnets it may be necessary to keep the magnets in a fixed position. With the North-South axis of the magnets at right angle to the substrate that is to be cleaned, the magnets should be kept in a fixed position. With the North-South axis of the magnets parallel to the substrate that is to be cleaned the magnets may be rotated, however the centre line of the magnets should preferably coincide with the axis of rotation in order not to change the position of the magnetic field with respect to the substrate.

With the plasma surface cleaning treatment Ar gas or an Ar based gas is supplied to the ionisation chamber where it is ionised to a plasma due to a voltage difference (for instance in the order of inner unit 300-3000V) between the container defining the ionisation chamber (anode) and the grounded steel substrate and wherein the Ar ions subsequently bombard the steel surface (grounded) due to the voltage difference. To realise an efficient cleaning operation it is a prerequisite that the Ar gas and subsequently the Ar ions are evenly distributed over the surface area to be cleaned.

According to a further aspect of the invention it is provided that the gas supply is connected to a gas tube inside the ionisation chamber and wherein the gas tube is provided with a plurality of nozzles.

Typically it is further provided that the nozzles are directed to the opening of the ionisation chamber, which in operation means that the nozzles are directed to the surface area of a substrate to be cleaned.

It is further provided that the gas tube runs parallel to the at least one row of magnets. In a typical configuration the gas tube with the nozzles is at a distance from the at least one row of magnets with the row of magnets between the gas tube and the substrate to be cleaned. With that part of the gas flows over and along the shielding of the row(s) of magnets therewith preventing that at least part of the debris is deposited on the shielding of the row(s) of magnets and is taken away from the shielding by the gas flow.

As an alternative embodiment it is provided that the gas tube is positioned between a row of magnets and the opening defined by the support for a substrate. In this configuration the gas tube is between the row of magnets and the surface area of the substrate that is cleaned.

Alternatively gas tubes are provided on both sides of a row of magnets as seen in a direction at a right angle to the opening of the ioinisation chamber. With a number of rows of magnets the gas tubes could be positioned on both sides of such an assembly of rows of magnets or at both sides of each row of magnets. With the gas tubes positioned as indicated it is further provided that the gas tubes run parallel to the rows of magnets.

Typically the plasma cleaning apparatus is operated within a vacuum environment resulting in that at least part of the Ar gas feed flow will leave the plasma cleaning apparatus and enters the vacuum environment. The invention aims to use the Ar gas feed flow to prevent the deposition of debris, resulting from the cleaning of the steel substrate, in the ionisation chamber and/or on the shielded row of magnets as much as possible. A first feature is the positioning of the gas tube or the gas tubes with respect to the shielded rows of magnets as described above.

A further feature comprises that the plasma cleaning apparatus is provided with at least one outflow opening for the supplied gas at a position between the magnets in the ionisation chamber and the location or path of the substrate to be cleaned with the apparatus in operation.

According to a further feature the container defining the ionisation chamber is contained in an outer shielding container provided with an opening, wherein the opening of the ionisation chamber and the opening of the outer container are in register and wherein ionisation chamber and outer container are electrically insulated from each other.

According to a further aspect the shielding container is around most or all of the ionisation chamber and spaced from the ionisation chamber by means of nonconductive spacers.

It is further provided that the at least one outflow opening is provided in the outer container and comprises at least one slit shaped opening. The outer shielding container is grounded and by providing the outflow opening in the outer shielding container also the material defining the outflow opening is grounded, if made from an electrically conductive material. Since the outflow opening or openings are close to the substrate that is to be cleaned, which is grounded in order for the plasma cleaning process to work, it is preferred to have the outflow opening(s) in the outer shielding container.

It was found that by providing that the outflow opening comprises at least one slit shaped opening, the flow of the Ar gas feed could be regulated such that part of the debris resulting from the cleaning operation could be entrained to outside the ionisation chamber without that the ionisation of the Ar gas is influenced too much.

According to a further aspect it is provided that outflow openings are at more than one side of the shielding container, for instance at opposite positions in the shielding container near opposite ends of the row(s) of magnets in the ionisation chamber. According to a further aspect the outflow openings are provided at three or more sides of the support. With these configurations of outflow openings the Ar gas flow is along the shielded row of magnets to the outflow openings with which it is prevented that a part of the debris is deposited on the shielding of the rows of magnets.

### Brief description of the drawings

The invention will be further explained by reference to the examples shown in the drawing, in which:
- fig. 1: shows a schematic cross-section of a plasma cleaning apparatus.
- fig. 2: shows schematically a partial cross-section of a row of magnets, cooling tube, shielding and gas tube, and
- fig. 3: shows a schematic cross-section of a first and a second plasma cleaning apparatus positioned at opposite sides of a substrate to be cleaned, with the substrate in vertical position.

### Detailed description of the drawings

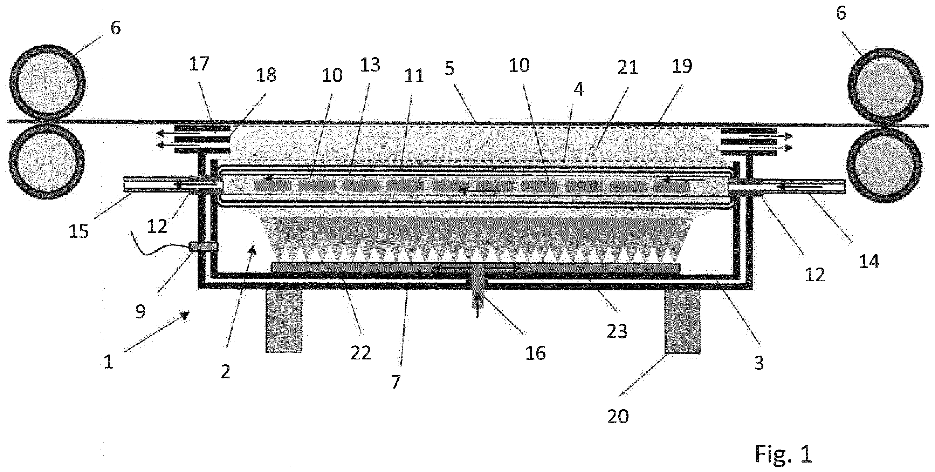

In fig.1 a magnetron sputter unit or plasma cleaning apparatus 1 is shown comprising an ionisation chamber 2 in which an Ar gas is ionized into a plasma. The ionisation chamber 2 comprises a container 3 with an opening 4 at the side where a steel strip 5 is guided over the ionisation chamber 2. The steel sheet 5 is supported by rolls 6 which may also serve as transport rolls to transport the steel strip over the plasma cleaning device 1.

The container 3 of the ionisation chamber 2 is positioned in a shielding container 7 which is at a distance from and not in contact with container 3 for instance by non electrically conductive spacers not shown in the drawing. The shielding container 7 is grounded whereas the container 3 of the ionisation chamber 2 is kept at a voltage with respect to the steel strip 5 for the ionisation and plasma forming in ionisation chamber 2. The voltage is applied to container 3 by means of electric connection 9, which is guided insulated through shielding container 7 and connects to container 3.

Inside the ionisation chamber 2 a number of permanent magnets 10 are provided in one or more rows. In the example of fig.1 the magnets 10 are inside a hollow shielding 11 of a non magnetic material, wherein the shielding is provided with hollow pivot axis 12 that extend till outside container 7 and are insulated from container 3 of ionisation chamber2. The pivot axis 12 provide that the hollow shielding 11 can be rotated from outside the containers 3,7.

The magnets 10 are mounted inside a separate tube 13 wherein the tube 13 is provided with an inlet and outlet line 14,15 which are coaxially with the pivot axis 12 and extend till outside pivot axis to connect these to a cooling medium system. With this set-up the magnets 10 can be kept in position while the shielding 11 can be rotated depending on the amount of debris on the shielding 11 between the magnets 10 and the substrate to be cleaned.

Depending on the orientation of the magnets 10 in the shielding 11, that is whether or not rotation of the shielding 11 makes a difference to the orientation of the magnetic field, the shielding 11 can be used to hold permanent magnets 10 in position and be used as cooling tube wherein hollow pivot axis 12 are connected to a cooling liquid supply system to cool permanent magnets 10.

The shielding container 7 has an opening 19 which is in register with the opening 4 of the container 3 of ionisation chamber 2.

A supply line 16 for Argon gas or Argon based gas is provided which connects to a gas tube 22 inside ionisation chamber 2 that extends over at least part of the ionisation chamber 2 and is provided with a number of nozzles 23 to distribute the Ar gas over the ionisation chamber 2. The supply line 16 is insulated from shielding container 7 and container 3. The gas tube 22 is positioned parallel or about parallel to the shielding 11 and as a result the gas flows around shielding 11 in the direction of the substrate 5 to be cleaned. In the outer shielding container 7 outflow openings 17 are provided for Ar gas flowing out of the ionisation chamber 2 taking along debris removed from steel sheet 5 by plasma cleaning. The outflow openings 17 are slit or grid shaped and are provided near and/or adjacent to the substrate 5 to be cleaned along at least part of the circumference of container 7 and typically along most or even all sides of container 7.

The outflow openings 17 shown in the drawing are slit shaped wherein the slits run at an angle to the sides of shielding container 7 and parallel or about parallel to the substrate 5 to be cleaned. The slits are defined by parallel strips of material 18, for instance steel strips, that are supported by shielding container 7. The shielding container is grounded and so are the parallel strips 18 if made from electrically conductive material. In the embodiment shown in the drawing the substrate 5 is very near the last, most outward strip 18 and with that also a slit shaped outflow opening is defined between the last strip 18 and the substrate 5.

The last strip could also function as a support for a substrate 5 such as a steel sheet 5, since the strips 18 are either grounded like the substrate 5 or are not electrically conductive. However, with steel strip 5 the preferred option would be to use rolls 6 and keep a certain distance between the steel strip 5 and the last strip 18 of the ooutflow openings 17. To that end the magnetron sputter unit 1 is provided with a distance control system 20 to move the unit 1 to and from the steel strip 5 to keep the unit at a certain distance from the steel strip 5.

In operation the positive ions are accelerated towards the steel substrate 5 to be cleaned by a voltage difference between container 3 and the substrate which is grounded. To increase the density of the plasma 21 near the steel surface, the magnets 10 are used to capture electrons and thereby increase their ionization efficiency. The row of magnets 10 is located on the front side of the steel sheet, that is the side of the steel sheet 5 that is to be cleaned, inside the ionisation chamber 2. This has the major advantage that the thickness of the steel sheet 5 does not affect the sputtering process. In contrast thereto by placing the magnets 10 on the other side of the steel sheet 5, the ferromagnetic steel will short circuit part of the magnetic field thereby reducing its efficiency especially for thicker substrates. However at the front side of the steel sheet 5, the magnets 10 will be contaminated by the surface material removed from the front side of the steel sheet 5.

The contamination problem is solved or diminished by providing two features which can be used individually or combined to improve the operation time of the plasma sputter unit 1. With the plasma pre-treatment of the surface of the steel sheet 5 prior to the coating deposition, removes surface material which will subsequently be re-deposited inside the ionisation chamber 2. This causes short-circuit effects, contamination problems and a reduced efficiency of the surface treatment of the steel sheet 5 by lowering the magnetic field. By using and optimizing the Ar feed flow for the plasma, removed surface material can be guided to a large extent to outside of the sputter unit 1. This prevents the build-up of debris to a large degree.

One or more rows of magnets 10 are used to densify the plasma 21 near the surface of the steel sheet 5. The removed and re-deposited surface material (Fe) would arrive at least partly on top of the magnets 10 causing a reduction of the magnetic field therewith lowering the plasma sputtering efficiency. By providing a rotatable shielding 11 of non-magnetic material around the magnets 10, for example of aluminium or copper, the effect of shielding the magnetic field by the iron-debris is strongly reduced.

By combining an optimized Ar gas flow with a shielding 11 the contamination of the plasma sputter unit 1 will be strongly reduced with the result of an increased runtime.

A third feature is the cooling system provided to cool the magnets 10. Since the magnets 10 are close to the steel strip 5, which heats up as function of sputtering the magnets 10 need to be cooled to maintain their magnetic properties. Since the magnets 10 are inside the ionisation chamber 2 and inside container 3, which is under a high positive voltage (the steel strip is grounded) the cooling system is electrically insulated from container 3.

The plasma surface pre-treatment consist of an Ar based gas which is being fed through supply line 16 and gas tube 22 to inside the ionisation chamber 2. A voltage difference (inner unit 300-3000V) between the container 3 of ionisation chamber 2 and steel strip 5 creates Ar ions which subsequently bombard the steel surface (grounded) due to the voltage difference. The power supply is DC or pulsed DC with a typical frequency between 30 and 250 kHz. The Ar gas flow and the power used are adjusted depending on the required sputter rate of the steel surface. To this end it is further provided that the position of gas tube 22 inside ionisation chamber 2 is adjustable, that is supply line 16 and therewith gas tube 22 can be moved so as to change the distance between gas tube 22, nozzles 23 with respect to the magnets 10 and shielding 11.

All these measures take care of removing surface material and activating the steel surface prior to coating deposition by for example PVD while keeping the plasma cleaning apparatus 1 sufficiently clean from debris for a long time. This is a key step to obtain good coating adhesion properties. By having a well-defined Ar flow into the sputter unit, the removed surface material can be forced/guided out of the critical positions of the sputter unit.

The plasma cleaning apparatus 1 with the row(s) of magnets 10 inside the ionisation chamber 2 allows to have a second cleaning apparatus 1 at the other side of substrate 5 and opposite to the first cleaning apparatus 1. With that configuration both sides of substrate 5 can be plasma cleaned at the same time. Moreover, with this configuration to plasmae clean both sides of the substrate 5 at the same time, a relatively compact build of the plasma cleaning installation can be realized.

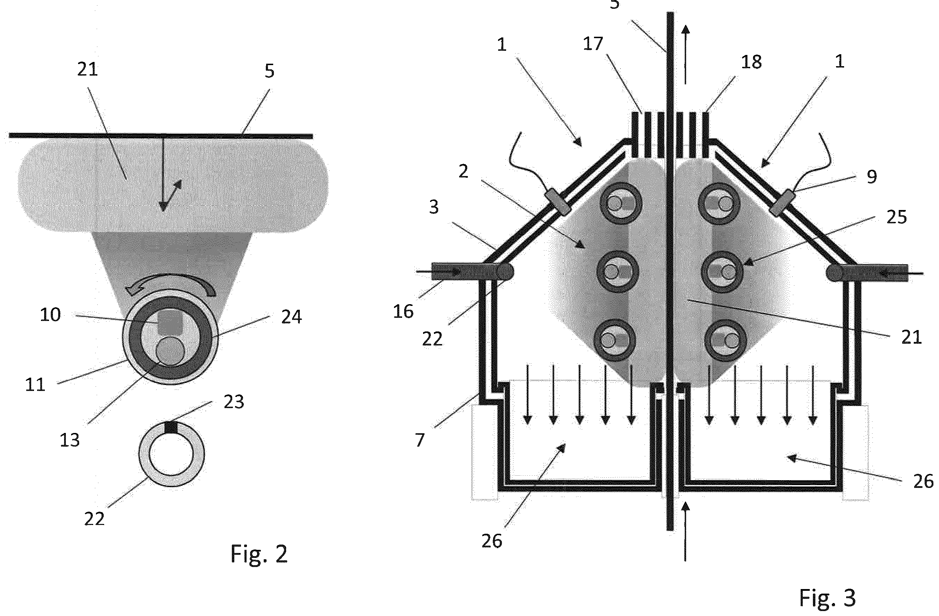

In fig. 2 schematically a cross-section is shown of a row of magnets 10, cooling tube 13, shielding 11 and gas tube 22. In this embodiment the cooling tube 13 and the magnets 10 are retained in a retaining tube 24. The retaining tube 24 is provided coaxially with shielding 11 and shielding 11 is independently rotatable with respect of retaining tube 24.

Fig. 3 shows a schematic cross-section of a first and a second plasma cleaning apparatus 1 positioned at opposite sides of a substrate 5 to be cleaned, with the substrate in vertical position. With the magnets 10 inside the ionisation chamber 2 of the plasma cleaning apparatus 1 has the advantage that the substrate 5 can be plasma cleaned at directly opposing sides at the same time. The container 3 and shielding container 7 are adapted to form a receptacle 26 to receive debris dropping of the shieldings 11 of the rows of magnets 10. The configuration of the rows of magnets 10, with cooling tube 13, retaining tube 24 and shielding 11 is as in fig. 2 and the assembly as a whole is indicated with 25. All other parts of the plasma cleaning apparatuses 1 have the same reference numbers as in fig. 1 as far as appropriate.

The design of containers 3, 7 and the positioning of the gas supply 16 and gas tube 22 is such that the gas flows along the sides of the rows of magnets 25, helping to keep the shieldings 11 free from debris as much as possible, part of which is entrained with the gas stream through the outflow openings to outside the plasma cleaning apparatus 1 and part of which ends up in receptacle 26.

Not further indicated in the drawing but receptacle 26 can be detachable mounted to provide easy cleaning of the receptacle 26. As a further feature scrubbers can be provided inside the plasma cleaning apparatus to clean the shieldings 11 from time to time. This can be done for instance at the side of the shielding facing away from the substrate to be cleaned and in the length direction of the shielding 11.

## Claims

1. Plasma cleaning apparatus comprising an ionisation chamber (2) provided with an opening (4), wherein with the apparatus in operation the opening is facing a substrate to be cleaned, a gas supply (16), a power supply for the ionisation of the gas, a plurality of magnets (10) provided in at least one row parallel to a plane defined by the opening (4) of the ionisation chamber (2), wherein the plurality of magnets (34) are placed inside the ionisation chamber (2) and **characterized in that** the at least one row of magnets (34) is contained in a shielding (11) of non-magnetic material.

2. Plasma cleaning apparatus according to claim 1, wherein the plurality of magnets (34) are provided in three rows arranged parallel to each other

3. Plasma cleaning apparatus according to claim 1 or 2, wherein the shielding (11) of the row of magnets (34) is mounted rotatable in the ionisation chamber

4. Plasma cleaning apparatus according to claim 1 or 3, wherein the shielding (11) is provided with pivot axles (12) at opposite ends which are in line with each other and wherein at least one of the pivot axles (12) protrudes to outside the ionisation chamber.

5. Plasma cleaning apparatus according to claim 4, wherein the shielding (11) is a closed body and wherein the pivot axles (12) at opposite ends provide respectively an inlet and an outlet (14, 15) for a cooling medium

6. Plasma cleaning apparatus according to claim 4, wherein a cooling tube (13) for a cooling medium is provided inside the shielding (11) and wherein the pivot axles (12) of the shielding connect to the cooling tube and serve as inlet and outlet (14, 15) for the cooling medium.

7. Plasma cleaning apparatus according to claim 4, wherein a cooling tube (13) for a cooling medium is provided inside the shielding (11), wherein the pivot axles (12) of the shielding (11) are hollow, wherein an inlet line and an outlet line for a cooling medium are provided coaxially inside the pivot axis (12), wherein inlet line and an outlet line and pivot axis are rotatable with respect to each other, and wherein inlet line and an outlet line connect to the cooling tube (13).

8. Plasma cleaning apparatus according to claim 6 or 7, wherein the row of magnets (34) in the shielding (11) are provided inside the cooling tube (13) for the cooling medium.

9. Plasma cleaning apparatus according to claim 6 or 7, wherein the row of magnets (34) in the shielding (11) are provided against the cooling tube for the cooling medium.

10. Plasma cleaning apparatus according to one or more of the previous claims, wherein the gas supply is connected to a gas tube (22) inside the ionisation chamber and wherein the gas tube (22) is provided with a plurality of nozzles (23).

11. Plasma cleaning apparatus according to claim 10, wherein the nozzles (23) are directed to the opening (4) of the ionisation chamber (2).

12. Plasma cleaning apparatus according to claim 10, wherein the gas tube (22) runs parallel to the at least one row of magnets (34).

13. Plasma cleaning apparatus according to claim 10, wherein gas tubes (22) are provided on both sides of a row of magnets (34) as seen in a direction at a right angle to the opening (4) of the ionisation chamber (2).

14. Plasma cleaning apparatus according to one or more of the previous claims, wherein the apparatus is provided with at least one outflow opening (17) for the supplied gas at a position between the magnets (34) in the ionisation chamber (2) and the location or path of the substrate to be cleaned with the apparatus in operation.

15. Plasma cleaning apparatus according to any of the previous claims, wherein the ionisation chamber (2) is contained in an outer shielding container (7) provided with an opening, wherein the opening (4) of the ionisation chamber (2) and the opening of the outer container are in register and wherein ionisation chamber (2) and outer container are electrically insulated from each other.

16. Plasma cleaning apparatus according to claim 14, wherein the at least one outflow opening (17) is provided in the outer container (7) and comprises at least one slit shaped opening.

17. Plasma cleaning apparatus according to any of the previous claims, wherein the ionisation chamber (2) is provided with a recess to receive debris from the plasma cleaning operation.

## Patentansprüche

1. Plasmareinigungsvorrichtung, umfassend eine Ionisationskammer (2), die mit einer Öffnung (4) versehen ist, wobei die Öffnung im Betrieb der Vorrichtung einem zu reinigenden Substrat zugewandt ist, eine Gaszufuhr (16),
eine Stromversorgung für die Ionisation des Gases, mehrere Magnete (10), die in mindestens einer Reihe parallel zu einer durch die Öffnung (4) der Ionisationskammer (2) definierten Ebene vorgesehen sind, wobei die mehreren Magnete (34) im Inneren der Ionisationskammer (2) platziert sind, und
**dadurch gekennzeichnet, dass** die mindestens eine Reihe von Magneten (34) in einer Abschirmung (11) aus nicht-magnetischem Material enthalten ist.

2. Plasmareinigungsvorrichtung nach Anspruch 1, wobei die mehreren Magnete (34) in drei parallel zueinander angeordneten Reihen vorgesehen sind.

3. Plasmareinigungsvorrichtung nach Anspruch 1 oder 2, wobei die Abschirmung (11) der Reihe von Magneten (34) in der Ionisationskammer drehbar montiert ist.

4. Plasmareinigungsvorrichtung nach Anspruch 1 oder 3, wobei die Abschirmung (11) an gegenüberliegenden Enden mit Schwenkachsen (12) versehen ist, die miteinander fluchten und wobei mindestens eine der Schwenkachsen (12) aus der Ionisierungskammer herausragt.

5. Plasmareinigungsvorrichtung nach Anspruch 4, wobei die Abschirmung (11) ein geschlossener Körper ist und wobei die Schwenkachsen (12) an gegenüberliegenden Enden jeweils einen Einlass und einen Auslass (14, 15) für ein Kühlmedium bereitstellen.

6. Plasmareinigungsvorrichtung nach Anspruch 4, wobei im Inneren der Abschirmung (11) ein Kühlrohr (13) für ein Kühlmedium vorgesehen ist und wobei die Schwenkachsen (12) der Abschirmung an das Kühlrohr anschließen und als Einlass und Auslass (14, 15) für das Kühlmedium dienen.

7. Plasmareinigungsvorrichtung nach Anspruch 4, wobei im Inneren der Abschirmung (11) ein Kühlrohr (13) für ein Kühlmedium vorgesehen ist, wobei die Schwenkachsen (12) der Abschirmung (11) hohl sind, wobei eine Einlassleitung und eine Auslassleitung für ein Kühlmedium koaxial im Inneren der Schwenkachse (12) vorgesehen sind,
wobei Einlassleitung und eine Auslassleitung und Schwenkachse in Bezug zueinander drehbar sind, und wobei Einlassleitung und eine Auslassleitung an dem Kühlrohr (13) anschließen.

8. Plasmareinigungsvorrichtung nach Anspruch 6 oder 7, wobei die Reihe von Magneten (34) in der Abschirmung (11) im Inneren des Kühlrohrs (13) für das Kühlmedium vorgesehen ist.

9. Plasmareinigungsvorrichtung nach Anspruch 6 oder 7, wobei die Reihe von Magneten (34) in der Abschirmung (11) gegen das Kühlrohr für das Kühlmedium vorgesehen sind.

10. Plasmareinigungsvorrichtung nach einem oder mehreren der vorhergehenden Ansprüche, wobei die Gaszufuhr mit einem Gasrohr (22) im Inneren der Ionisationskammer verbunden ist und wobei das Gasrohr (22) mit mehreren Düsen (23) versehen ist.

11. Plasmareinigungsvorrichtung nach Anspruch 10, wobei die Düsen (23) auf die Öffnung (4) der Ionisationskammer (2) gerichtet sind.

12. Plasmareinigungsvorrichtung nach Anspruch 10, wobei das Gasrohr (22) parallel zu der mindestens einen Reihe von Magneten (34) verläuft.

13. Plasmareinigungsvorrichtung nach Anspruch 10, wobei Gasrohre (22) auf beiden Seiten einer Reihe von Magneten (34) vorgesehen sind, in einer Richtung rechtwinklig zu der Öffnung (4) der Ionisationskammer (2) gesehen.

14. Plasmareinigungsvorrichtung nach einem oder mehreren der vorhergehenden Ansprüche, wobei die Vorrichtung mit mindestens einer Ausströmöffnung (17) für das zugeführte Gas an einer Position zwischen den Magneten (34) in der Ionisationskammer (2) und der Position oder dem Weg des zu reinigenden Substrats mit der Vorrichtung in Betrieb vorgesehen ist.

15. Plasmareinigungsvorrichtung nach einem der vorhergehenden Ansprüche, wobei die Ionisationskammer (2)
in einem äußeren Abschirmbehälter (7) vorgesehen ist, der
mit einer Öffnung versehen ist, wobei die Öffnung (4) der Ionisationskammer (2) und die Öffnung des äußeren Behälters deckungsgleich sind und wobei die Ionisationskammer (2) und der äußere Behälter elektrisch voneinander isoliert sind.

16. Plasmareinigungsvorrichtung nach Anspruch 14, wobei die mindestens eine Ausströmöffnung (17) in dem äußeren Behälter (7) vorgesehen ist und mindestens eine schlitzförmige Öffnung umfasst.

17. Plasmareinigungsvorrichtung nach einem der vorangehenden Ansprüche, wobei die Ionisationskammer (2) mit einer Aussparung versehen ist, um Abfall von dem Plasmareinigungsvorgang aufzunehmen.

## Revendications

1. Appareil de nettoyage par plasma comprenant une chambre d'ionisation (2) munie d'une ouverture (4), où, lorsque l'appareil est en service, l'ouverture fait face à un substrat à nettoyer, une alimentation en gaz (16), une alimentation électrique pour l'ionisation du gaz, une pluralité d'aimants (10) fournis dans au moins une rangée parallèle à un plan défini par l'ouverture (4) de la chambre d'ionisation (2), où la pluralité d'aimants (34) sont placés à l'intérieur de la chambre d'ionisation (2) et
**caractérisé en ce que** la ou les rangées d'aimants (34) sont contenues dans un blindage (11) de matériau non magnétique.

2. Appareil de nettoyage par plasma selon la revendication 1, où la pluralité d'aimants (34) sont fournis en trois rangées disposées parallèlement entre elles.

3. Appareil de nettoyage par plasma selon la revendication 1 ou 2, où le blindage (11) de la rangée d'aimants (34) est monté de manière rotative dans la chambre d'ionisation.

4. Appareil de nettoyage par plasma selon la revendication 1 ou 3, où le blindage (11) est muni d'axes de pivotement (12) à des extrémités opposées qui sont alignées l'une avec l'autre et où au moins l'un des axes de pivotement (12) dépasse à l'extérieur de la chambre d'ionisation.

5. Appareil de nettoyage par plasma selon la revendication 4, où le blindage (11) est un corps fermé et où les axes de pivotement (12) aux extrémités opposées fournissent respectivement une entrée et une sortie (14, 15) pour un agent de refroidissement.

6. Appareil de nettoyage par plasma selon la revendication 4, où un tube de refroidissement (13) pour un agent de refroidissement est fourni à l'intérieur du blindage (11) et où les axes de pivotement (12) du blindage sont reliés au tube de refroidissement et servent d'entrée et de sortie (14, 15) pour l'agent de refroidissement.

7. Appareil de nettoyage par plasma selon la revendication 4, où un tube de refroidissement (13) pour un agent de refroidissement est fourni à l'intérieur du blindage (11), où les axes de pivotement (12) du blindage (11) sont creux, où une conduite d'entrée et une conduite de sortie pour un agent de refroidissement sont fournies coaxialement à l'intérieur de l'axe de pivotement (12), où une conduite d'entrée et une conduite de sortie et l'axe de pivotement peuvent pivoter l'un par rapport à l'autre, et où une conduite d'entrée et une conduite de sortie sont reliées au tube de refroidissement (13).

8. Appareil de nettoyage par plasma selon la revendication 6 ou 7, où la rangée d'aimants (34) dans le blindage (11) sont fournis à l'intérieur du tube de refroidissement (13) pour l'agent de refroidissement.

9. Appareil de nettoyage par plasma selon la revendication 6 ou 7, où la rangée d'aimants (34) dans le blindage (11) sont fournis contre le tube de refroidissement pour l'agent de refroidissement.

10. Appareil de nettoyage par plasma selon l'une quelconque des revendications précédentes, où l'alimentation en gaz est reliée à un tube à gaz (22) à l'intérieur de la chambre d'ionisation et où le tube à gaz (22) est muni d'une pluralité de buses (23).

11. Appareil de nettoyage par plasma selon la revendication 10, où les buses (23) sont dirigées vers l'ouverture (4) de la chambre d'ionisation (2).

12. Appareil de nettoyage par plasma selon la revendication 10, où le tube à gaz (22) est parallèle à la ou aux rangées d'aimants (34).

13. Appareil de nettoyage par plasma selon la revendication 10, où des tubes à gaz (22) sont fournis des deux côtés d'une rangée d'aimants (34), vus dans une direction perpendiculaire à l'ouverture (4) de la chambre d'ionisation (2).

14. Appareil de nettoyage par plasma selon l'une ou plusieurs des revendications précédentes, l'appareil étant muni d'au moins une ouverture de débit sortant (17) pour le gaz fourni à un emplacement entre les aimants (34) dans la chambre d'ionisation (2) et l'emplacement ou chemin du substrat à nettoyer avec l'appareil en service.

15. Appareil de nettoyage par plasma selon l'une quelconque des revendications précédentes, où la chambre d'ionisation (2) est contenue dans un conteneur de blindage extérieur (7) muni d'une ouverture, où l'ouverture (4) de la chambre d'ionisation (2) et l'ouverture du conteneur extérieur correspondent, et où la chambre d'ionisation (2) et le conteneur extérieur sont isolé électriquement l'un de l'autre.

16. Appareil de nettoyage par plasma selon la revendication 14, où la ou les ouvertures de débit sortant (17) sont fournies dans le conteneur extérieur (7) et comprennent au moins une ouverture en forme de fente.

17. Appareil de nettoyage par plasma selon l'une quelconque des revendications précédentes, où la chambre d'ionisation (2) est munie d'un logement pour recevoir les débris de l'opération de nettoyage par plasma.
